# EUROPÄISCHE PATENTSCHRIFT

(11) **EP 0 328 757 B1**
(45) Veröffentlichungstag und Bekanntmachung des Hinweises auf die Patenterteilung: **28.04.1993**
(21) Anmeldenummer: 88120397.0
(22) Anmeldetag: 07.12.1988
(51) Int. Cl.: H01L 39/12, H01L 39/24

(54) **Verfahren zur Herstellung dünner Schichten aus oxydischem Hochtemperatur-Supraleiter**
Method for manufacturing thin films from high Tc oxide superconductors
Procédé de fabrication de couches minces en supraconducteurs à Tc élevé de type oxyde

(30) Priorität: 18.02.1988 DE 3805010
(43) Veröffentlichungstag der Anmeldung: 23.08.1989
(73) Patentinhaber: FORSCHUNGSZENTRUM JÜLICH GMBH, 52425 Jülich (DE)
(72) Erfinder: Poppe, Ulrich, Dr., D-5000 Köln 41 (DE); Schubert, Jürgen, D-5000 Köln 50 (DE); Evers, Wilhelm, D-5170 Jülich (DE)

(56) Entgegenhaltungen:
- EP-A- 0 299 870
- EP-A- 0 329 929
- APPLIED PHYSICS LETTERS, Band 25, Nr. 25, 20. Juni 1988, Seiten 2183-2185, American Institute of Physics, New York, US; H. TAMURA et al.: "Ozone-UV irradiation effects on Ba2YCu3O7-x thin films"

## Beschreibung

Die Erfindung bezieht sich auf ein Verfahren zur Herstellung dünner Schichten aus Material eines oxydischen Hochtemperatur-Supraleiters, bei dem das Material als Target- bzw. Kathoden-Material eingesetzt und die Schicht durch Kathodenzerstäubung auf einem erhitzten Substrat durch Niederschläge gebildet wird und wobei in dem während der Glimmentladung ionisierten Gas Sauerstoff enthalten ist. Die Erfindung bezieht sich ferner auf eine Vorrichtung zur Durchführung des Verfahrens.

Ein derartiges Verfahren zur Herstellung dünner Schichten aus supraleitender Oxydkeramik ist aus Appl. Phys. Lett., Vol. 51 No. 9, 31. August 1987, Superconducting Y-Ba-Cu-O oxide films by sputtering, bekannt. Dabei hat sich gezeigt, daß zur Erzielung der gewünschten supraleitenden Eigenschaften der gebildeten Schichten bzw. Filme eine Nachtemperung in Sauerstoffatmosphäre bei Temperaturen im Bereich von 800°C bis 900°C erforderlich ist. Dieser nachträgliche Verfahrensschritt erfordert nicht nur zusätzlichen technischen Aufwand, er steht vielmehr auch wegen der bei diesen hohen Substrattemperaturen ablaufenden unerwünschten chemischen Reaktionen zwischen Substrat und Schicht einer breiteren technischen Anwendung des Verfahrens hindernd entgegen.

Es ist daher Aufgabe der Erfindung, das eingangs bezeichnete Verfahren derart weiterzuentwickeln, daß der nachteilige Verfahrensschritt der Nachtemperung entfällt. Aufgabe ist ferner, eine Vorrichtung zur Durchführung des Verfahrens zu schaffen.

Diese Aufgabe wird gemäß der Erfindung dadurch gelöst, daß die Kathodenzerstäubung bei einem Partialdruck des Sauerstoffs von wenigstens 67 Pa (0.5 Torr) reaktiv durchgeführt wird. Auf diese Weise erfolgt bereits während der Glimmentladung und während der Bildung der Schicht eine Anreicherung des die Schicht bildenden Materials mit Sauerstoff. Dies führt schon bei Temperaturen des Substrats von 450 bis ca. 770°C zu Schichten mit den angestrebten supraleitenden Eigenschaften, so daß der Verfahrensschritt der Nachtemperung entfällt.

Der einzustellende Partialdruck ist zwar nach oben hin dadurch begrenzt, daß eine selbständige O₂-Plasmaentladung stabilisiert werden muß. Der Druck sollte jedoch wenigstens 67 Pa (0,5 Torr) (möglichst 13.4 kPa (100 Torr) und mehr) betragen. Zur Einstellung dieses (möglichst hohen) Sauerstoffpartialdruckes sind die Verfahrensbedingungen entsprechend (beispielsweise kleiner Abstand zwischen Target und Substrat) zu wählen. Auch ist sauerstoffreiches Gasgemisch, bevorzugt reiner Sauerstoff zu verwenden. Hierdurch wird - außer daß eine Anreicherung des die Schicht bildenden Materials erreicht wird - auch verhindert, daß das Target an Sauerstoff verarmt.

Eine zweckmäßige Verfahrensmaßnahme zur Erhöhung des Sauerstoffpartialdruckes am Substrat besteht darin, daß dieses mit Sauerstoff oder Ozon bespült wird. Dies kann mittels eines Kapillarsystems geschehen, wodurch während der Durchführung des Verfahrens eine möglichst laminare O₂- bzw. O₃-Strömung an der Oberfläche des Substrats eingestellt wird.

Bei der Verfahrensweise gemäß Anspruch 4 wird Sauerstoff derart eingespeist, daß nicht nur der Ort der sich bildenden Schicht, sondern auch die Zone der der Schicht zufließenden Ionen mit Sauerstoff angereichert wird.

Eine weitere zweckmäßige Verfahrensmaßnahme, die der Erhöhung des O₂-Partialdruckes dienlich ist, besteht darin, daß der Gasraum zwischen Target und Substrat einer ionisierenden Strahlung ausgesetzt wird. Dies kann beispielsweise mittels einer starken Lichtquelle geschehen, deren Licht kontinuierlich oder gepulst in den Gasraum gesendet wird. Selbstverständlich können auch andere ionisierende Strahlen, wie Röntgen- oder Laserstrahlen oder eine radioaktive Strahlung, eingesetzt werden.

Eine Verbesserung der Herstellungsbedingungen wird auch dadurch erzielt, daß gemäß Anspruch 6 in den Gasraum zwischen Kathodenmaterial und Substrat Mikrowellen eingestrahlt werden. Diese bewirken einen sehr hohen Ionisationsgrad im Plasma, so daß mit dieser Maßnahme erreicht wird, daß die selbstständige Entladung im Plasma auch bei höheren Drucken im Gasraum (etwa 200 Torr / 2,7 x 10⁴ Pa) stattfindet. Ein weiterer Vorteil dieser Maßnahme besteht darin, daß durch die eingestrahlten Mikrowellen im Plasma selbst UV-Licht frei wird.

Eine weitere vorteilhafte Verfahrensvariante besteht darin, daß die Oberfläche des Substrats harter UV-Strahlung ausgesetzt wird. Dadurch wird durch Zufuhr nicht thermischer Energie etwa über elektronische Anregung das Schichtwachstum positiv beeinflußt. Weiterhin ist das gebildete Ozon sehr reaktiv. Es zersetzt sich auf dem heißen Substrat und somit steht an der sich bildenden Schicht mehr Bildungsenergie zur Verfügung, wodurch die Temperatur des Substrats niedriger gehalten werden kann.

Zur Durchführung des Verfahrens gemäß der Erfindung ist eine Vorrichtung mit den Merkmalen des Oberbegriffes des Anspruches 8 geeignet, bei der der Isolator zwischen Kathodenmaterial und Abschirmung vorgesehen ist, um Überschläge zwischen Kathodenmaterial und Abschirmung, die bei den hohen Gasdrucken auftreten könnten, zu verhindern. Zudem beträgt bei dieser Vorrichtung der Abstand zwischen Kathodenmaterial und Substrat wegen der sehr kurzen freien Weglänge bei den hohen Gasdrucken 5 bis 20 mm.

Zur Durchführung der Verfahrensvarianten, bei der in den Gasraum ionisierende Strahlung oder Mikrowellen gerichtet werden, sind Ausführungsformen der Vorrichtung gemäß den kennzeichnenden Merkmalen des Anspruches 9 bzw. des Anspruches 10 geeignet. Die Ausführung der Vorrichtung gemäß den kennzeichnenden Merkmalen des Anspruches 11 dient dagegen zur Durchführung der Verfahrensvariante, bei der die Substratoberfläche mit hartem UV-Licht bestrahlt wird.

Die weitere Ausführungsform der Vorrichtung gemäß Anspruch 12 ist für die Durchführung der Verfahrensvariante, bei der die Substratoberfläche mit Sauerstoff oder Ozon bespült wird, vorgesehen.

Im folgenden wird eine Vorrichtung gemäß der Erfindung, die in der Zeichnung schematisch dargestellt ist, näher erläutert. Es werden ferner Ausführungsbeispiele zum Verfahren gemäß der Erfindung angegeben.

Es zeigen
- Figur 1: Vorrichtung zur Durchführung des Verfahrens;
- Figur 2: Kathoden- und Anodenanordnung der Vorrichtung gemäß Figur 1 mit UV-Lampe;
- Figur 3: Widerstandskennlinie einer gemäß Ausführungsbeispiel 1 hergestellten Schicht;
- Figur 4: Ergebnisdiagramm einer Versuchsreihe unter Verwendung von reinem Sauerstoff als Gas und Einsatz einer ionisierenden Strahlung;
- Figur 5: Ergebnisdiagramm einer Versuchsreihe unter Verwendung eines O₂-Argon-Gasgemisches;
- Figur 6: Widerstandskennlinie einer gemäß Ausführungsbeispiel 4 hergestellten Schicht.

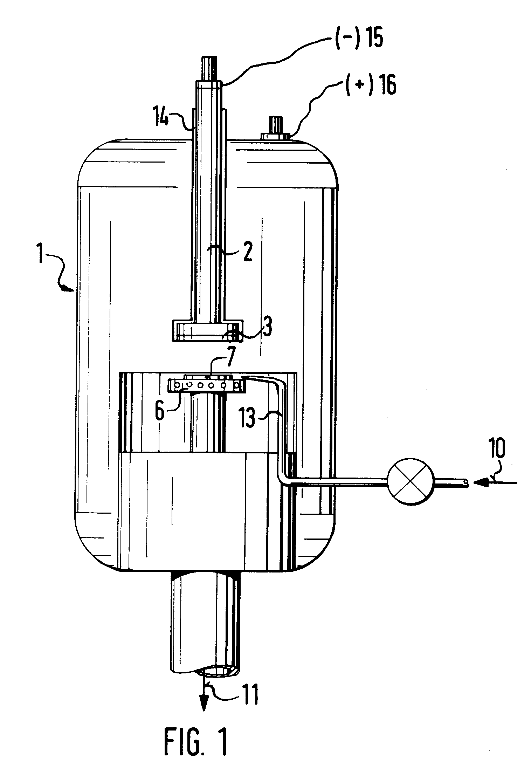

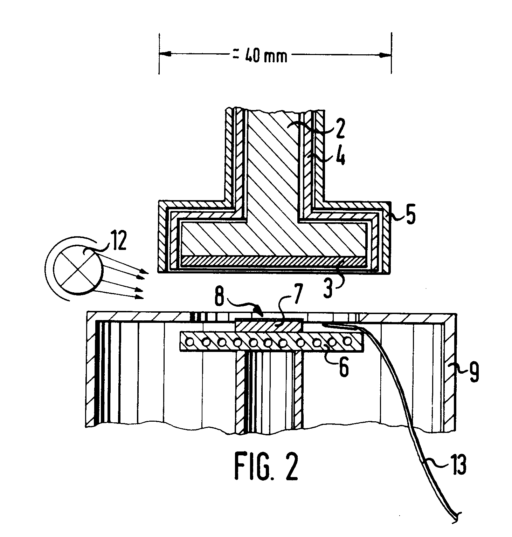

Wie aus Figur 1 ersichtlich ist, ragt von oben in die gasdichte Kammer 1 die aus Kupfer gefertigte Kathode 2, an deren unterem Ende das Target 3 (Kathodenmaterial) angebracht ist. Die Kupferkathode ist, wie aus Figur 2 ersichtlich ist, von einem Isolator 4 und einer Kupferabschirmung 5 umgeben. Ferner ist eine Einrichtung - die in der Zeichnung nicht dargestellt ist - zur Kühlung der Kathode vorgesehen.

Gegenüber dem Target 3 der Kathode befindet sich auf einem heizbaren Substrathalter 6 das Substrat 7, auf welchem die Schicht 8 aus dem supraleitenden Material aufgebracht werden soll. Der Substrathalter ist von einer gekühlten Kupferblende 9 umgeben.

Die Vorrichtung weist elektrische Anschlüsse auf. Die Kathode befindet sich bei Gleichspannungsbetrieb auf minus Potential, während Kupferabschirmung 5 und gekühlte Kupferblende 9 üblicherweise auf Null-Potential liegen.

Ferner ist eine Gaszuleitung 10 und ein Anschluß 11 für eine Pumpeinrichtung vorgesehen. Eine Einrichtung 12 ist seitlich des Gasraumes zu dessen Bestrahlung mit ionisierter Strahlung angebracht. Zum Bespülen der Substratoberfläche ist ein als Kapillare 13 dargestelltes Kapillarsystem vorgesehen.

### Ausführungsbeispiele:

Die nachfolgend angegebenen Ausführungsbeispiele wurden mit einer Vorrichtung der beschriebenen Art, jedoch mit unterschiedlichem Gas und wahlweise mit und ohne UV-Strahlung durchgeführt. Das Kapillarsystem mündete zwar in der Nähe des Substrats, war jedoch nicht geeignet, das Substrat mit Gas zu bespülen.

Der eingestellte Sauerstoff-Partialdruck betrug bei den Untersuchungen bis zu 667 Pa (5 Torr), bei den unten angegebenen Untersuchungen 333 Pa (2,5 Torr). Um Verunreinigungen des Sputtergases zu vermeiden, wurde der Druck dynamisch eingestellt. Während über das Kapillarsystem laufend Sauerstoff in der Nähe des Substrats eingelassen wurde, wurde über den Anschluß 11 mit einer Pumpe mit hohem Saugvermögen gepumpt. Als Pumpe wurde eine Kryopumpe (Zeolith mit flüssigem Stickstoff gekühlt) mit relativ hohem Saugvermögen eingesetzt.

Die an der Kathode angelegte Spannung lag im Bereich zwischen 150 und 250 Volt, der Strom im Bereich von 50 bis 150 mA. Bei diesen Bedingungen hatte der Dunkelraum der Kathode nur eine Tiefe von 0,5 bis 2 mm. Der Abstand zwischen Substrat und Target betrug 10 mm. Der Durchmesser des kreis- und plattenförmigen Targets aus YBa₂Cu₃O₇ betrug ca. 35 mm.

### Ausführungsbeispiel 1: (reiner Sauerstoff und UV-Licht)

Es wurden bei sieben unterschiedlichen Substrattemperaturen Schichten von YBa₂Cu₃O₇ auf SrTiO₃ aufgebracht. Anschließend wurden die Widerstandswerte der Schichten im Temperaturbereich von Zimmertemperatur bis etwa 64 K und insbesondere im Bereich der starken Widerstandsabnahme um 90 K gemessen.

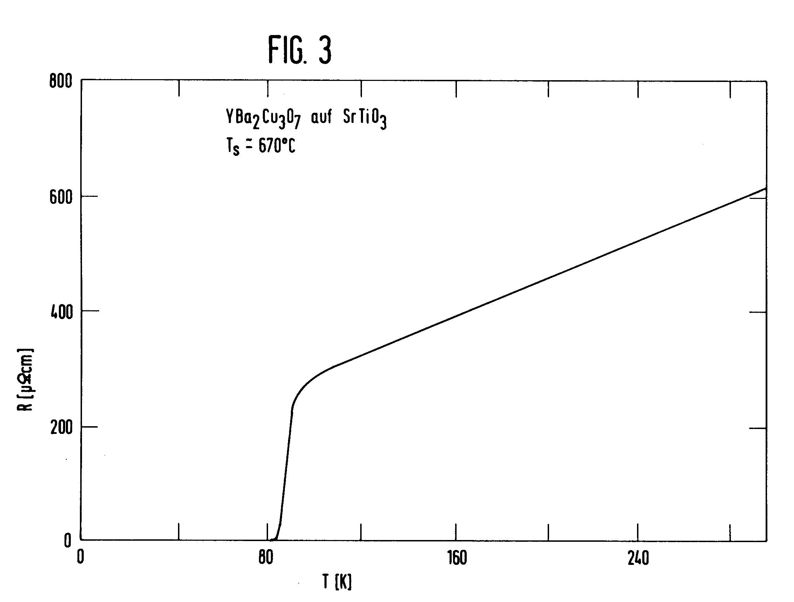

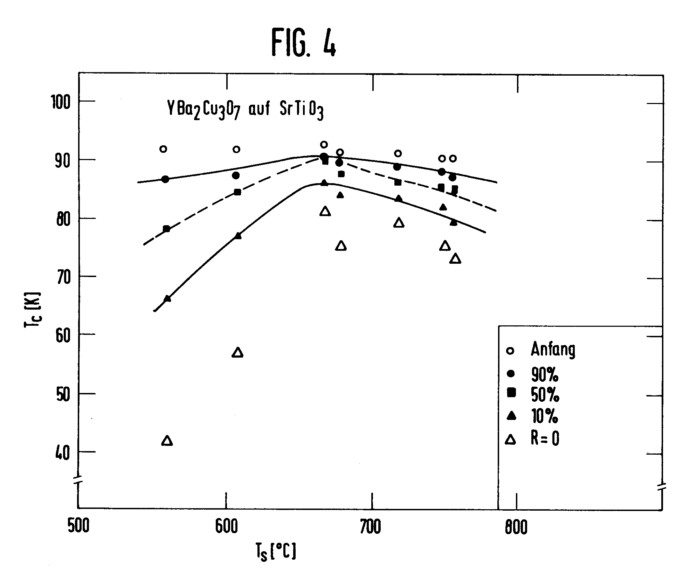

Figur 3 zeigt die Widerstandskurve einer Schicht, welche bei einer Substrattemperatur (Tₛ) von 670°C hergestellt worden war. Die Kurve zeigt im Bereich um 90 K (Tₖ) eine starke Widerstandsabnahme zur Supraleitung. In diesem Bereich wurden die Widerstandswerte (R) bei Beginn des Abfalls, bei 90, 50 und 10 % dieses Wertes sowie bei Erreichen des Wertes 0 gemessen. Diese Werte sind in Figur 4 im Vergleich zu den entsprechenden Werten der übrigen, bei anderen Substrattemperaturen hergestellten Schichten angegeben. Die Darstellung in Figur 3 (Tₛ: Substrattemperatur; R: Widerstand) zeigt, daß auch bei den bei niederen Substrattemperaturen hergestellten Schichten die starke Widerstandsabnahme bei 91 K beginnt. Daraus geht hervor, daß schon bei den niedrigeren Substrattemperaturen ein Anteil der supraleitenden Phase mit hoher Sprungtemperatur gebildet worden ist und eine Optimierung des Verfahrens (etwa über die Zusammensetzung des Targetmaterials) auch unterhalb der Temperatur von 650°C zu Schichten mit hoher Übergangstemperatur führt.

Wie weitere Untersuchungen ergaben, sind alle hergestellten Schichten epitaktisch mit der c-Achse senkrecht zum Substrat. Die kritische Stromdichte der bei 670°C hergestellten Schicht lag oberhalb 10⁶ A/cm² bei 6 K.

Die hergestellten Schichten haben außerdem sehr glatte Oberflächen mit einer Oberflächenrauhigkeit von < 0,1 µm, so daß einer Mikrostrukturierung in kryoelektronischen Anwendungen nichts im Wege steht.

### Ausführungsbeispiel 2: (reiner Sauerstoff, kein UV-Licht)

Ohne Einstrahlung von UV-Licht, jedoch unter sonst gleichen Bedingungen wie in Ausführungsbeispiel 1 wurden zwei Schichten bei 670°C Substrattemperatur hergestellt. Die YBa₂Cu₃O₇-Schichten auf SrTiO₃ wiesen eine breitere Übergangskurve der Widerstandskennlinie zur Supraleitung auf. Der Widerstand verschwand nicht bei 81 K, wie bei der in Figur 3 dargestellten Kennlinie, sondern erst bei 70 bzw. 75 K. Dies zeigt den positiven Einfluß der UV-Strahlung.

### Ausführungsbeispiel 3: (Gasgemisch, UV-Licht)

Es wurden Schichten von YBa₂Cu₃O₇ auf SrTiO₃ bei drei unterschiedlichen Substrattemperaturen hergestellt, wobei ein Gasgemisch von 90 % Sauerstoff und 10 % Argon verwendet wurde. Ansonsten waren die Bedingungen die gleichen wie in Ausführungsbeispiel 1.

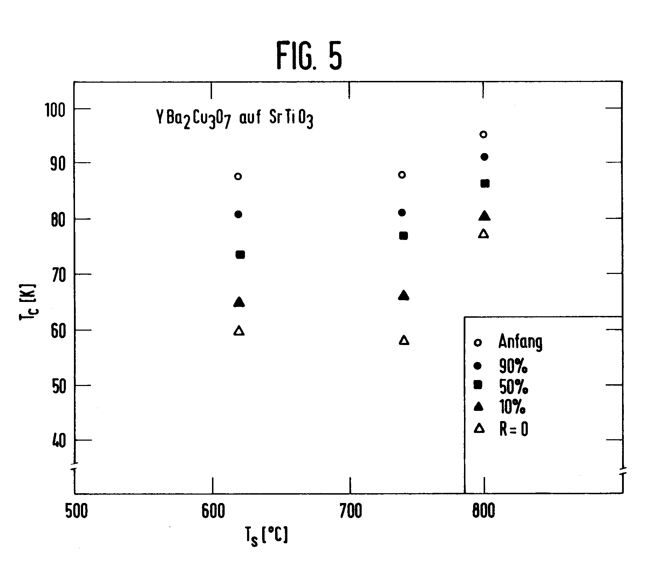

Aus der Widerstandskennlinie in Figur 5 sind breitere Übergangsbreiten zur Supraleitung zu entnehmen als aus Figur 4. Dies zeigt, daß der Einsatz von Argon, d. h. der Einbau von Argon in die Schichten, deren supraleitende Eigenschaften negativ beeinflußt.

### Ausführungsbeispiel 4: (reiner Sauerstoff, UV-Licht)

Es wurden drei Schichten auf einem Substrat aus oxidiertem Silicium bei Substrattemperaturen um etwa 560°C hergestellt. Die Bedingungen entsprachen ansonsten den Bedingungen gemäß Ausführungsbeispiel 1.

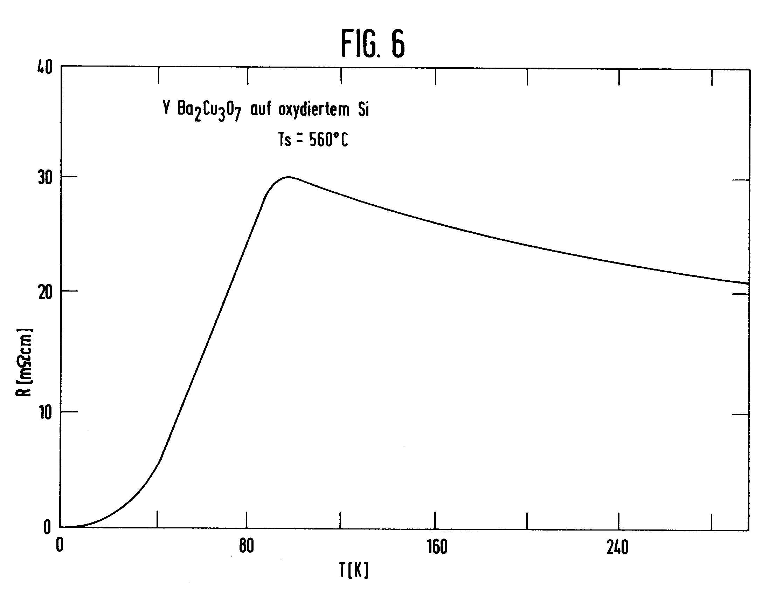

In Figur 6 ist der Widerstandsverlauf einer YBa₂Cu₃O₇₋ Schicht wiedergegeben. Der Übergang zur Supraleitung ist zwar sehr breit, jedoch läßt der hohe Einsatzpunkt bei etwa 90 K erkennen, daß durch Optimierung des Sputterprozesses (etwa durch Änderung der Targetzusammensetzung) die supraleitenden Eigenschaften verbessert werden können.

Die Benutzung von Silicium als Substrat ist im Hinblick auf eine kombinierte Anwendung von supraleitenden und konventionellen halbleitenden Bauelementen anzustreben.

## Patentansprüche

1. Verfahren zur Herstellung dünner Schichten aus Material eines oxydischen Hochtemperatur-Supraleiters, bei dem das Material als Target- bzw. Kathoden-Material eingesetzt und die Schicht durch Kathodenzerstäubung auf einem erhitzten Substrat durch Niederschlag gebildet wird und wobei in dem während der Glimmentladung ionisierten Gas Sauerstoff enthalten ist,
**dadurch gekennzeichnet,**
daß die Kathodenzerstäubung bei einem Partialdruck des Sauerstoffs von wenigstens 67 Pa (0,5 Torr) reaktiv durchgeführt wird.

2. Verfahren nach Anspruch 1,
**dadurch gekennzeichnet,**
daß als Gas reiner Sauerstoff verwendet wird.

3. Verfahren nach Anspruch 1 oder 2,
**dadurch gekennzeichnet,**
daß zur Erhöhung des Sauerstoffpartialdruckes am Substrat (7) dieses mit Sauerstoff oder Ozon bespült wird.

4. Verfahren nach einem der Ansprüche 1 bis 3,
**dadurch gekennzeichnet,**
daß zur Erhöhung des Sauerstoffpartialdruckes am Substrat Sauerstoff oder Ozon am Target so eingespeist und das Gas so abgesaugt wird, daß der eingespeiste Sauerstoff oder das Ozon in einer laminaren Strömung vom Target (3) zum Substrat (7) gelangt.

5. Verfahren nach einem der Ansprüche 1 bis 4,
**dadurch gekennzeichnet,**
daß der Gasraum zwischen Target (3) und Substrat (7) einer ionisierenden Strahlung ausgesetzt wird.

6. Verfahren nach einem der Ansprüche 1 bis 5,
**dadurch gekennzeichnet,**
daß in den Gasraum zwischen Kathodenmaterial (3) und Substrat (7) Mikrowellen eingestrahlt werden.

7. Verfahren nach einem der Ansprüche 1 bis 6,
**dadurch gekennzeichnet,**
daß die Oberfläche des Substrats (7) harter UV-Strahlung ausgesetzt wird.

8. Vorrichtung zur Herstellung dünner Schichten aus Material eines oxydischen Hochtemperatur-Supraleiters, die aus in einer gasdichten Kammer angeordneter Kathoden- und Anoden-Anordnung besteht, wobei dem Target- bzw. dem Kathoden-Material ein beheizbarer Substrathalter gegenüberliegt, und die Kammer außerdem Gaszuleitung und Anschluß für eine Pumpeinrichtung aufweist,
**dadurch gekennzeichnet,**
daß die Kathode (2) von einem Isolator (4) umgeben ist, der sich zwischen Kathode und der die Kathode umgebenden Abschirmung (5) befindet und daß der Abstand zwischen Kathodenmaterial (3) und Substrat (7) 5 bis 20 mm beträgt.

9. Vorrichtung nach Anspruch 8,
**dadurch gekennzeichnet,**
daß eine Einrichtung (12) zur Bestrahlung des zwischen Kathodenmaterial (3) und Substrat (7) liegenden Gasraums mit ionisierender Strahlung vorgesehen ist.

10. Vorrichtung nach Anspruch 8 oder 9,
**dadurch gekennzeichnet,**
daß eine Einrichtung zum Bestrahlen des zwischen Kathodenmaterial (3) und Substrat (7) liegenden Gasraums mit Mikrowellen vorgesehen ist.

11. Vorrichtung nach Anspruch 8 bis 10,
**dadurch gekennzeichnet,**
daß eine Einrichtung (12) zur Bestrahlung der Oberfläche des Substrats (7) mit hartem UV-Licht vorgesehen ist.

12. Vorrichtung nach einem der Ansprüche 8 bis 11,
**dadurch gekennzeichnet,**
daß ein Kapillarsystem (13) zum Bespülen der Oberfläche des Substrats (7) mit einem Gas vorgesehen ist.

## Claims

1. A process for producing thin films of an oxidic hightemperature superconductor material, in which the material is used as the target or cathode material and the film is formed by deposition on a heated substrate by means of cathodic sputtering, and wherein oxygen is contained in the gas ionized during the glow-discharge, characterised in that the cathodic sputtering is carried out reactively at an oxygen partial pressure of at least 67 Pa (0.5 Torr).

2. A process according to claim 1, characterised in that pure oxygen is used as the gas.

3. A process according to claim 1 or 2, characterised in that to increase the oxygen partial pressure at the substrate (7) the latter is flushed with oxygen or ozone.

4. A process according to claims 1 to 3, characterised in that to increase the oxygen partial pressure at the substrate oxygen or ozone is fed in at the target and the gas is extracted by suction so that the oxygen or ozone fed in reaches the substrate (7) from the target (3) in laminar flow.

5. A process according to any one of claims 1 to 4, characterised in that the gas space between the target (3) and the substrate (7) is exposed to an ionising radiation.

6. A process according to any one of claims 1 to 5, characterised in that microwaves are beamed into the gas space between the cathode material (3) and the substrate (7).

7. A process according to any one of claims 1 to 6, characterised in that the surface of the substrate (7) is exposed to hard UV radiation.

8. A device for producing thin films of an oxidic hightemperature superconductor material, which consists of a cathode and anode arrangement disposed in a gas-tight chamber, wherein a heated substrate holder is disposed opposite the target or the cathode material, and the chamber additionally has a gas inlet and a connection for a pump device, characterised in that the cathode (2) is surrounded by an insulator (4) which is located between the cathode and the screen (5) surrounding the cathode, and that the distance between the cathode material (3) and the substrate (7) is 5 to 20 mm.

9. A device according to claim 8, characterised in that a device (12) is provided for irradiating the gas space between the cathode material (3) and the substrate (7) with ionising radiation.

10. A device according to claims 8 or 9, characterised in that a device is provided for irradiating the gas space between the cathode material (3) and the substrate (7) with microwaves.

11. A device according to claims 8 to 10, characterised in that a device (12) is provided for irradiating the surface of the substrate (7) with hard UV radiation.

12. A device according to any one of claims 8 to 11, characterised in that a capillary system (13) is provided for flushing the surface of the substrate (7) with a gas.

## Revendications

1. Procédé pour fabriquer des couches minces en un matériau d'un supraconducteur à base d'oxydes à température de transition élevée, dans lequel le matériau est utilisé comme matériau de cible ou matériau de cathode, et la couche est formée par pulvérisation cathodique par déposition sur un substrat chauffé, le gaz ionisé pendant la décharge luminescente contenant de l'oxygène, caractérisé en ce que la pulvérisation cathodique est mise en oeuvre d'une manière réactive sous une pression partielle d'oxygène d'au moins 67 Pa (0,5 mm Hg).

2. Procédé selon la revendication 1, caractérisé en ce que le gaz utilisé est l'oxygène pur.

3. Procédé selon la revendication 1 ou 2, caractérisé en ce que, pour augmenter la pression partielle d'oxygène du substrat (7), on balaye ce dernier par de l'oxygène ou de l'ozone.

4. Procédé selon l'une des revendications 1 à 3, caractérisé en ce que, pour augmenter la pression partielle d'oxygène du substrat, on injecte de l'oxygène ou de l'ozone sur la cible et on aspire le gaz de façon que l'oxygène injecté ou l'ozone s'écoule selon un écoulement laminaire de la cible (3) au substrat (7).

5. Procédé selon l'une des revendications 1 à 4, caractérisé en ce que l'espace gazeux situé entre la cible (3) et le substrat (7) est exposé à un rayonnement ionisant.

6. Procédé selon l'une des revendications 1 à 5, caractérisé en ce que des microondes sont injectées dans l'espace gazeux situé entre le matériau de cathode (3) et le substrat (7).

7. Procédé selon l'une des revendications 1 à 6, caractérisé en ce que la surface du substrat (7) est exposée à un rayonnement UV dur.

8. Dispositif pour fabriquer des couches minces en le matériau d'un supraconducteur à base d'oxydes à température de transition élevée, constitué d'un agencement de cathode et d'anode disposé dans un compartiment étanche aux gaz, un support chauffable de substrat étant placé en regard du matériau de cible ou du matériau de cathode, le compartiment comportant en outre une conduite d'amenée de gaz et une prise pour un dispositif de pompage, caractérisé en ce que la cathode (2) est entourée d'un isolateur (4), lequel se trouve entre la cathode et le bouclier (5) qui entoure la cathode, et que la distance entre le matériau de cathode (3) et le substrat (7) est de 5 à 20 mm.

9. Dispositif selon la revendication 8, caractérisé en ce qu'on prévoit un système pour irradier avec un rayonnement ionisant l'espace gazeux situé entre le matériau de cathode (3) et le substrat (7).

10. Dispositif selon la revendication 8 ou 9, caractérisé en ce qu'on prévoit un système pour envoyer des microondes dans l'espace gazeux situé entre le matériau de cathode (3) et le substrat (7).

11. Dispositif selon les revendications 8 à 10, caractérisé en ce qu'on prévoit un système (12) destiné à exposer à une lumière UV dure la surface du substrat (7).

12. Dispositif selon l'une des revendications 8 à 11, caractérisé en ce qu'on prévoit un système à capillaire (13) pour balayer par un gaz la surface du substrat (7).
